# EUROPEAN PATENT APPLICATION

(11) **EP 3 598 231 A1**
(43) Date of publication of application: **22.01.2020**
(21) Application number: 18183749.3
(22) Date of filing: 16.07.2018
(51) Int. Cl.: G03F 1/22, G03F 1/24, G03F 7/20

(54) **METHOD FOR MODIFYING A LITHOGRAPHIC MASK**

(71) Applicant: Carl Zeiss SMS Ltd., 2015600 Misgav (IL)
(72) Inventor: Oshemkov, Sergey, 2166323 Karmiel (IL); Kruglyakov, Vladimir, 23109 Migdal haEmek (IL); Cohen, Avi, 3465433 Haifa (IL); Perets, Yuval, Moshav Beit Shearim (IL)
(74) Representative: Carl Zeiss SMT GmbH

(57) **Abstract**

A method of treating a mask for use in extreme ultraviolet (EUV) photolithography is provided. In this method a design region on the mask to be imaged onto a wafer and a border region surrounding the design region is defined. Then a first set of treatment parameters of a first treatment to produce a reduction in reflectance at a working wavelength of EUV radiation is determined and a first treatment beam with the first set of treatment parameters is directed onto the border region. Secondly a second set of treatment parameters different from the first set of treatment parameters of a second treatment is determined to enhance a reduction in reflectance and a second treatment beam with the second set of treatment parameters is directed onto the border region.

## Description

As miniaturization of integrated circuits continues, photolithography processes that use deep ultraviolet (DUV) radiation are often inadequate, typically at the wavelength of 193 nm. In order to support the further miniaturization, radiation with a wavelength that is an order of magnitude shorter than that of DUV radiation is required. Developers of photolithography processes have turned to extreme ultraviolet (EUV) radiation. For example, EUV photolithography may utilize radiation at the wavelength 13.5 nm. A typical 13.5 nm radiation source includes a plasma (e.g., a laser-produced plasma) in which the radiation is produced.

A photolithography system based on EUV radiation differs in several aspects from a system based on DUV radiation. A DUV system typically involves transmitting optics (e.g., lenses). A DUV photomask typically involves a transparent substrate upon which a pattern of reflecting or absorbing material is deposited. Since EUV radiation is absorbed by materials, all EUV lithography optics are based on reflection, rather than transmission and refraction. Typical EUV optics is based on multilayer reflectors that reflect radiation as determined by Bragg's Law. The multilayer reflectors typically include a large number (e.g., 40 to 50, or more or fewer) of alternating layers of molybdenum (Mo) and silicon (Si). The reflectors are used in focusing and beam-directing optics, as well as in the photomask itself. A typical EUV photomask includes reflecting multilayer upon which an absorbing material is deposited. Process variations in lithographic printing of integrated circuits are characterized by variations in the sizes of structures (e.g. lines and spaces) printed on a substrate such as a silicon wafer.

Photolithographic masks must be largely error-free, since an error in the mask would reproduce on every wafer with every exposure. In a photolithographic mask, it is important that the pattern elements of the absorber structure on the photolithographic mask exactly map the structural elements specified by the design of the semiconductor device into the photoresist or photoresist on the wafer. The nominal size of the structural elements generated by the absorber pattern in the photoresist is called critical dimension (CD). This size and its variation (CDU Critical Dimension Uniformity) are central parameters for the quality of a photolithographic mask.

The pattern on the mask are transferred onto the wafer via a lithography lens system which in the Working wavelength of EUV radiation range is a purely catoptric system. On the wafer a photosensitive resist is then exposed to the image of the mask. On the mask the region containing the patterns including all the support features that improve the imaging process, so called OPC (optical proximity correction) features is surrounded by a border region. This border region is usually called a black border because the reflectance there should be very low. Thus only very little radiation would be reflected from these black borders. The main problem now arises from the small amount of radiation that is still reflected from these black borders and reaches the photosensitive resist.

In DUV lithography the lightsources are usually Excimer lasers and as such produce light in a very narrow bandwidth. The EUV lightsources are plasma based. Typically in a laser produced plasma (LPP) source a tin droplet is evaporated and subsequently excited by an IR laser pulse. An excited plasma produces light in a large range of wavelength not just in a narrow line around the desired working wavelength of EUV radiation. The resist is not only sensitive to radiation near the working wavelength of EUV radiation, but also to radiation in other wavelengths. This leads to a problem from radiation reflected from the border regions around the design region of a mask not only from the reflected light in EUV but also from the reflected light in other wavelengths.

It is therefore an object of the current invention to provide a method to produce a black border on a mask used for EUV lithography in the working wavelength of EUV radiation and out of the Working wavelength of EUV radiation.

In a first aspect of the invention a method of treating a mask for use in extreme ultraviolet (EUV) photolithography is provided, the method comprising the steps:
a) Defining a design region on the mask to be imaged onto a wafer and a border region surrounding the design region,
b) Determining a first set of treatment parameters of a first treatment to produce a reduction in reflectance at a working wavelength of EUV radiation,
c) Directing a first treatment beam with the first set of treatment parameters onto the border region,
d) Determining a second set of treatment parameters different from the first set of treatment parameters of a second treatment to enhance a reduction in reflectance,
e) Directing a second treatment beam with the second set of treatment parameters onto the border region.

In present practice in the chip producing industry the border region of an EUV mask (black border) is an 2-3 mm wide surrounding the design area on the photomask. When printing a die at dense spacing on an EUV scanner, reflected light from the region next to the design region overlaps with the edges of neighboring dies affecting CD and contrast in this area. The amount of undesired light will depend on the reflectance of the border region. The reflectance is in general dependent on the material that is reflecting the light as well as the wavelength or wavelength ranges of the light that is reflected. The ideal aim would be to reduce the reflectance in the border region to zero for all wavelengths. Thus the name "black border" for the region of reduced reflectance is commonly used. This is not technically possible. Therefore the EUV reflectance within the border region should be as low as possible.

To prevent an impact on the critical dimension (CD) of the imaged mask structures or on the variation of critical dimension over an area (CDU "critical dimension uniformity") from field-to-field the border region on the mask should have an extremely low EUV reflectance. Current industry standards require a reflectance in the EUV-wavelength range of smaller than 0.1%.

The typical structure of an EUV mask is composed of a glass substrate with a very low coefficient of thermal expansion, a highly reflective multilayer and an absorber layer. Typical glass substrates are commercially available under the names of ULE or Zerodur. The highly reflective multilayer coating is often based on repeated layers of molybdenum and silicon, so called Mo/Si-layers. Several multilayer designs are common in the literature. It is also known to use cap-layers or systems of cap-layers on the side of the multilayer that is opposite to the substrate side. These work to protect the multilayer from environmental influences. An example would be the oxidation from traces of oxygen or more commonly water. Current industry standard is a cap-layer of ruthenium. The coating may contain barrier layers between the coating materials to prevent interdiffusion of these coating materials. Furthermore not only Mo/Si-layers can be used but they may be designed from different coating materials. Often further multilayers are added to provide additional functionality. E.g. anti-stress-layers may be added to reduce the coating stress. The reflective multilayer is added to the mask substrate over the entire area of the mask. This stage with this combination of material and reflective multilayer is sometimes referred to as a mask blank. The mask blank is essentially an EUV-mirror. Finally an absorber material is added on top of the mask blank to provide the pattern structures of the mask. This absorber is added within the design region only selectively. For example depending on the mask design there may be areas with lines and spaces of absorber material. Typical material that are used as an absorber are Al-Cu, Ti, TiN, Ta, TaN, and Cr. The person skilled in the art knows that several other options exist. In current mask design the height of the absorber is 50-80 nm.

One possible solution to provide a mask with a EUV-mask with a border region with very low reflectance would be to apply the absorber material in the border region surrounding the design region. The disadvantage is that very thick absorber layer would be needed. For comparison in a pattern within the design area the remaining reflectance within the EUV-wavelength range is around 1-5%. Thus exceeding the required 0.1% reflectance by at least one order of magnitude.

Conversely one would have to increase the absorber thickness significantly to reach a low reflectance. However, it is preferred to keep the absorber thin due to shadowing effects.

The alternatives that are currently used have in common a method step removing the multilayer and the absorber from the mask substrate. One way to achieve this is etching of the absorber/multilayer stack down to glass. Then only the reflectance in the working wavelength of EUV radiation of the glass substrate itself remains. To further reduce the reflectance of the border region surrounding the design region additional treatment of the glass substrate of the mask at the bottom of the etching trench has been suggested.

The drawback of all these methods is that since the combination of the multilayer stack and the absorber layer is higher than 300 nm. Therefore etching of the border region surrounding the design region of a EUV mask is not easy. Furthermore such a mask will be prone to degradation and contamination during lifetime, specifically during cleaning, because the sensitive silicon and molybdenum layers have been exposed to the environment. Also charging must be taken into account since the design region of an EUV mask where the multilayer and the absorber have been etched away in a border region surrounding the design region. This leads to an electrically isolated "island".

Finally in US patent application US 2016/037067 A1 it has been suggested to treat the border region with a laser beam providing smooth modification of multilayer stack and absorber layer in order to decrease the reflectance at a working wavelength of EUV radiation. The treatment can be done both from front side and back side of the photomask. The drawback of this approach is that the reflectance at a working wavelength of EUV radiation is not sufficiently reduced.

Another aspect is that EUV sources emit, besides the EUV light, also a broad band Out-of-Band (OOB) light. In particular, in the wavelength range 100-400 nm EUV resists are sensitive. This can cause additional exposure of EUV resists and CD change at the edges and in the corners of the fields and therefore has an impact on CD uniformity.

While the reflectance of the absorber layer at a working wavelength of EUV radiation is determined by the absorber height, the reflectance of OOB light is practically independent of the absorber height since the penetration length of DUV light into absorber is only a few nanometers. The absorber stack reflectance has a certain spectrum for 140-300 nm wavelengths with an average of ∼15%.

Therefore it is another object of the current invention to decrease the Out of Band light reflectance in a border region surrounding the design region on an EUV mask.

The inventors realized that the objective can be achieved by applying a two step treatment of the multilayer stack and absorber layer in the border region surrounding the design region of an EUV mask. As a first step a design region on the mask to be imaged onto a wafer and a border region surrounding the design region have to be defined. The design region will contain the patterned absorber structures including any OPC that may be present within the mask design. The design region can be defined as a simple geometrical region containing all pattern elements. It may be a rectangle, a square or a circle or any of a number of simple geometrical shapes. One possible way of defining the design region may be by finding the convex hull of all pattern elements. However, the method is not restricted to convex design regions. The definition of the design region may also be imported from a design program. The border region is then defined as a region surrounding the design region.

A first set of parameters of a first treatment to produce a reduction in reflectance at a working wavelength of EUV radiation is determined and a first treatment beam with the first set of treatment parameters is directed onto the border region. A second set of parameters different from the first set of parameters of a second treatment is determined to enhance a reduction in reflectance and a second treatment beam with the second set of treatment parameters is directed onto the border region.

The advantage of this two step approach is that different effects within the material of the border region can be reached with the different sets of treatment parameters of the treatment beams. The first and the treatment can be done either subsequently or simultaneously depending on the actual parameters within the first and second sets of parameters.

In an aspect of the invention the border region comprises a substrate, a reflective multilayer structure and an absorber layer. This has the advantage that no etching of the EUV-mask is required. This in turn has the advantage that the materials of the reflective multilayer are not exposed to the environment. This makes them less prone to degradation over lifetime and to contamination. Additionally the EUV-mask is easier and more cost effective to produce.

In another aspect of the invention the enhancement occurs at a working wavelength of EUV radiation and/or at an wavelength other than the working wavelength of EUV radiation. In this way the reflectance at a working wavelength of EUV radiation can be further reduced by a second set of treatment parameters. So if the first treatment did not reache the required low reflectance a second treatment with different parameters can be used to reduce the reflectance at a working wavelength of EUV radiation further. Since the first treatment with the first set of treatment parameters has already used one physical or chemical treatment it is necessary to use a different physical or chemical effect with the second set of treatment parameters to reduce the reflectance at a working wavelength of EUV radiation further. Alternatively the second treatment with the second set of treatment parameters can be used to reduce the reflectance at a wavelength other than the working wavelength of EUV radiation. This has the advantage of reducing the reflectance at the working wavelength of EUV radiation as well as in the OOB range of region. The second set of treatment parameters can then determined based on the OOB wavelength that is relevant. Since the effect of the wavelength other than the working wavelength of EUV radiation is that the resist at the wafer is sensitive to this OOB wavelength as well, the second set of treatment parameters can be determined based on the properties of the resist. Depending on the sensitivity of the resist for a first resist one wavelength range other than the working wavelength of EUV radiation may be important and for a second resist a different wavelength range other than the working wavelength of EUV radiation. This would in turn lead to different sets of second treatment parameters. It is also possible to have a first treatment with first treatment parameters that effects a change in both the reflectance at the working wavelength of EUV radiation and additionally at a wavelength other than the working wavelength of EUV radiation. In this case the second treatment with second treatment parameters would reduce the reflectance at the working wavelength of EUV radiation or the reflectance at a wavelength other than the working wavelength of EUV radiation or both.

In another aspect of the invention a pulsed laser is used as the first and/or the second treatment beam. The laser can be a femtosecond, attosecond or other pulsed laser. To provide high spatial resolution of BB formation high NA objectives up to 0.9NA and shorter wavelength of laser radiation should be used - for example, 355 nm (3-d harmonic) or 266 nm (4th harmonic) of YAG laser. It is also possible to use 3-d harmonic of Ti:Sapphire laser (260- 266) nm. Particle beams like electron beams or ion beams may be used as well as treatment beams.

In another aspect of the invention the first set of parameters and/or the second set of parameters is selected from a group of parameters consisting of pulse energy, pulse duration, pulse rate, exposure time, scan rate, focal length, distance, pitch of a scanning pattern, a laser spot size on the border region and multiple laser spot positions.

In another aspect of the invention two or more laser spots impinge on significantly overlapping areas in the border region. Usually the spot of the first or the second treatment on the border region of the EUV mask are significantly smaller than the typical size of the border region. If the laser spots significantly overlapping areas this means that during scanning of the whole border region each point of the border region is treated with several pulses. This slow variation leads to a smoothly varying treatment of the border region.

One effect of a laser beam on the multilayer stack and absorber layer in the border region is a change of the structure of the multilayer stack. In the case of a Mo/Si reflective multilayer stack the treatment with a laser beam has two effects. Intermixing of Mo and Si layers is introduced which in turn leads to the formation of molybdenum silicides (MoxSiy). On the other hand the geometrical compaction of the reflective multilayer stack leads to a shift of the central wavelength of the multilayer reflectance spectra to shorter wavelengths. Both effects lead to a decrease in the reflectance with respect to a working wavelength of EUV radiation. If the spot sizes and the spot positions of the laser spots on the border region are chosen in such a way that the overlap significantly, a smooth compaction of the border region can be achieved. The advantage is that on the one hand the reflectance at a working wavelength of the EUV radiation in the border region is reduced due to the aforementioned effects. On the other hand the microroughness is kept small so that no additional unwanted stray light at the working wavelength of the EUV radiation is introduced.

In another aspect of the invention the smooth variation of the border region is chosen in a particular geometrical shape. The simplest shape is a constant compaction of the whole border region. In this case only the aforementioned effects of changing the reflectance are efficacious. If a different shape is chosen an additional effect of geometrical optics can be used. A linear cross section of the smoothly varying border region effectively reflects any remaining unwanted light in a different direction. Thus most of this residual reflected light will no longer reach the wafer. This leads not to an additional reduction of the border region of the EUV mask itself, but to a reduction of the border region of the EUV mask within the whole optical path from mask to wafer in the lithography process. Several variation on this idea are possible. One could also use a quadratic cross section. Since the border region is two-dimensional one could use in one direction in the plane of the border region one cross section (constant, linear or quadratic) and a different cross section in a different direction in the plane of the border region. Other smoothly varying function are also possible.

In another aspect of the invention the second treatment introduces a plurality of distinct compaction areas within the border region. The inventors found that it is advantageous to have distinct compaction areas in the border region, since they introduce a new degree of freedom in shaping the border region. Each distinct compaction area can be shaped as a simple indentation. They could be roughly of paraboloid shape. Alternatively the compaction areas within the border region can be shaped as a depression with a central nano-needle. The new degrees of freedom in placing the distinct compaction areas within the border region are the shape of each distinct area e.g. paraboloid or with central nano-needle, the size e.g. a diameter of each distinct area, and the positions of the distinct areas. They can be arranged in any way. Depending on the size the distinct areas can increase the roughness in a controlled was. The reflectance of the border region is then reduced by scattering the light into lightpaths that do not end on the wafer. The scattering effect will depend on the size of the distinct compaction areas. This size of the compaction areas will therefore be connected with wavelength range of the scattered radiation. The distinct compaction areas can be arranged in an irregular pattern in the border region. This arrangement can be chosen, when scattering of light is the dominant physical mechanism.

In another aspect of the invention the distinct compaction areas are arranged in a regular grid. A regular grid will be characterized by a pitch i.e. the distance from one minimum to the next. Depending on the size of the distinct compaction areas diffraction may become a second physical effect that reduces the reflectance of the border region. This can be of particular use at a wavelength other than the working wavelength of the EUV radiation. It could even be possible to affect two wavelength regions with a regular grid of distinct compaction areas. In this instance the scattering effect brings about a reduction of reflectance in the border region surrounding the design region in one wavelength range e.g. a DUV range from 100-400nm and the diffraction effect of the regular grid of the distinct compaction areas brings about a reduction in reflectance in a second wavelength range e.g. the infrared wavelength of the laser used in a laser produced plasma source.

The distinct compaction areas can also be arranged in a grid that has two different pitches in different direction in the plane of the mask. It is also possible to create two or more interlocking grids with the same pitch or with different pitches. In one of the grids the distinct compaction areas could contain a central nano-needle while in the other grid the would be paraboloid depressions.

In another aspect of the invention two or more laser spots impinge without overlap in the border region. With laser spots that do not overlap it is possible to create distinct compaction areas within the border region surrounding the design region.

In another aspect of the invention the first treatment is applied before the second treatment. In all previous embodiments the words first treatment and second treatment as well as first set of treatment parameters and second set of treatment parameters mean only that these instances are different treatments or sets of treatment parameters. The first treatment can be distinguished from the second. They are not necessarily meant to be applied in this temporal order. It is advantageous to apply the first treatment before the second treatment.

In particular it is possible to define a design region on the mask to be imaged onto a wafer and a border region surrounding the design region to define a first set of treatment parameters to produce a reduction in reflectance at a working wavelength of EUV radiation, directing a first treatment beam with the first set of treatment parameters onto the border region, where the first treatment introduces a smooth compaction of the border region, after the first treatment, determining a second set of parameters different from the first set of parameters of a second treatment to produce a reduction in reflectance in an wavelength other than the working wavelength of EUV radiation, directing a second treatment beam with the second set of treatment parameters onto the border region, where the second treatment introduces a plurality of distinct compaction areas within the border region.

This particular process can also be done in the different order: Defining a design region on the mask to be imaged onto a wafer and a border region surrounding the design region, defining a first set of treatment parameters to produce a reduction in reflectance at a working wavelength of EUV radiation, directing a first treatment beam with the first set of treatment parameters onto the border region, where the first treatment introduces a smooth compaction of the border region, before the first treatment, determining a second set of parameters different from the first set of parameters of a second treatment to produce a reduction in reflectance in an wavelength other than the working wavelength of EUV radiation, directing a second treatment beam with the second set of treatment parameters onto the border region. where the second treatment introduces a plurality of distinct compaction areas within the border region.

In another aspect of the invention the first set of parameters and the second set of parameters comprises a laser fluence on the border region. The laser fluence determines the effect that the laser light has on the multilayer stack and the absorption layer. The laser dose must be kept below the damage threshold of the multilayer stack and the absorption layer. In this way distinct compaction areas can be produced. If the laser fluence is increased the distinct compaction areas will start to develop a central nano-needle.

Therefore it is another aspect of the invention to chose the peak laser fluence on the border region in the first treatment to be lower than the peak laser fluence on the border region in the second treatment.

In another aspect of the invention the first and/or the second treatment are applied from the surface of the substrate opposite to the absorber pattern. It can be advantageous to apply the treatment beam not through the absorber layer to the underlying multilayer stack. It is a known technique to apply the treatment beam from the backside. The backside is the side of the substrate of the EUV mask that is opposite of the multilayer stack and the absorption layer. To make a precise control of the first or the second treatment beam possible, it is advantageous to coat the substrate of the EUV mask on the side opposite of the multilayer stack and the absorption layer with a thin transparent but electrically conductive backside coating.

Another aspect of the invention is an EUV-mask that has been treated by any of the previous methods.

### BRIEF DESCRIPTION OF THE DRAWINGS

Fig. 1 schematically illustrates light being reflected from different regions of an EUV-Mask onto a wafer.
Fig. 2 schematically illustrates the regions on a wafer that are affected by the reflection of light from a border region.
Fig. 3 schematically illustrates the structure of an EUV-mask.
Fig. 4 schematically illustrates the structure of an EUV-mask with a border treated by the method according to the invention.
Fig. 5 schematically illustrates the treatment of an EUV-mask with a treatment beam of an EUV-mask with a reflective multilayer stack and an absorption layer.
Fig. 6 schematically illustrates the treatment of an EUV-mask with a treatment beam from the side of an EUV-mask opposite to the side with a reflective multilayer stack and an absorption layer.
Fig. 7 schematically illustrates the experimental results of a part of an EUV-mask being treated with a smooth compaction region (top view).
Fig. 8 schematically illustrates the experimental results of a part of an EUV-mask being treated with a smooth compaction region (cross-section).
Fig. 9 schematically illustrates the experimental results of a part of an EUV-mask being treated with a distinct compaction area with a troughlike compaction. (top view).
Fig. 10 schematically illustrates the experimental results of a part of an EUV-mask being treated with a distinct compaction area with a troughlike compaction. (cross-section).
Fig. 11 schematically illustrates the experimental results of a part of an EUV-mask being treated with a distinct compaction area with a troughlike compaction with a nano-needle inside. (top view)
Fig. 12 schematically illustrates the experimental results of a part of an EUV-mask being treated with a distinct compaction area with a troughlike compaction with a nano-needle inside. (cross-section).
Fig. 13 schematically illustrates the experimental results of a part of an EUV-mask being treated with a combination of a smooth compaction region as well as with a regular grid of distinct compaction areas with a troughlike compaction. (top view)
Fig. 14 schematically illustrates the experimental results of a part of an EUV-mask being treated with a combination of a smooth compaction region as well as with a regular grid of distinct compaction areas with a troughlike compaction. (cross-section)

### List of reference numbers

2 Imaging light for photolithography
4 Imaging light for photolithography reflected from border region
6 current die
7 previous die
8 Image of mask on wafer (die)
9 region affected by reflected light from border region of the EUV-mask
10 design region on EUV-mask
12 border region surrounding design region on EUV-mask
14 distinct compaction area
16 smooth compaction area
18 wafer
19 EUV-mask
20 reflective multilayer stack
21 surface of the EUV-mask opposite of the reflective multilayer stack and the absorption layer
23 cap-layer of the EUV-mask
24 treated region of the EUV-mask
25 absorption layer of the EUV-mask
26 substrate of the EUV-mask
27 transparent coating on surface 21 of the EUV-mask
30 EUV-mask treatment system
31 alternate EUV-mask treatment system
32 treatment radiation source
34 optics
36 first or second treatment beam
38 controller
40 processor
46 translative motion

### DETAILED DESCRIPTION OF THE INVENTION

In the following detailed description, numerous specific details are set forth in order to provide a thorough understanding of the invention. However, it will be understood by those of ordinary skill in the art that the invention may be practiced without these specific details. In other instances, well-known methods, procedures, components, modules, units and/or circuits have not been described in detail so as not to obscure the invention.

The terms "plurality" or "a plurality" may be used throughout the specification to describe two or more components, devices, elements, units, parameters, or the like. Unless explicitly stated, the method embodiments described herein are not constrained to a particular order or sequence. Additionally, some of the described method embodiments or elements thereof can occur or be performed simultaneously, at the same point in time, or concurrently. Unless otherwise indicated the conjunction "or" as used herein is to be understood as inclusive (any or all of the stated options).

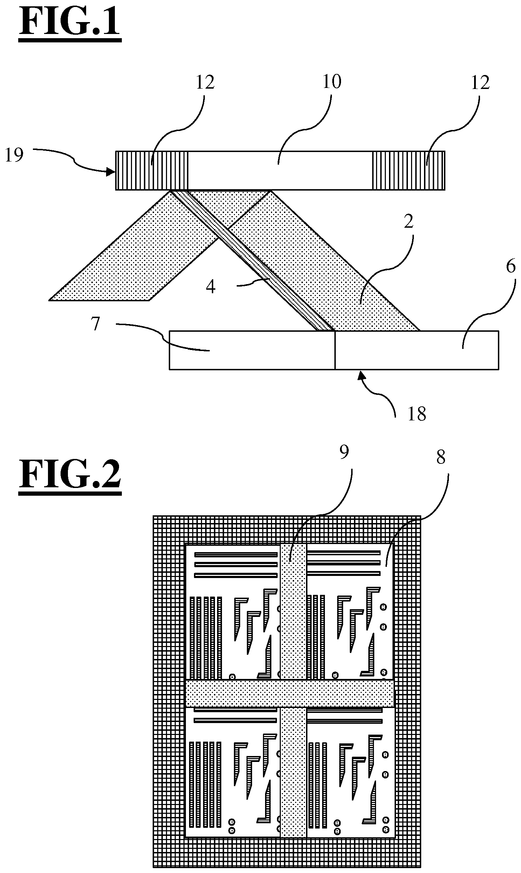

Figs. 1 and 2 illustrate the problem to be solved. In Fig. 1 light 2 e.g. EUV-light in a working wavelength of EUV radiation (commonly centered around 13.5 nm with a wavelength range of +/- 0.15 nm) impinges on the EUV-mask 19 and is reflected onto the wafer 18 after passing through the projection optics system (not shown). The design region 10 of the EUV-mask 19 contains the patterns that are needed for the chip structure. This design region 10 is surrounded by a border region 12. Light 4 that hits the border region 12 may still pass through the projection optics system and reach the wafer 18. However, since it is not reflected from the design region 10, but from a border region 12 offset a set amount from the design region 10, it is also imaged onto a region on the wafer 18 offset from the image that is currently exposed 6 by the lithography system. There may already have been a previous exposure 7 at this position. The resist will receive an additional amount of dose. This ultimately leads to a different CD in some regions on the wafer and therefore to a variation in CD (CDU) over the complete image 8 (die). The affected regions 9 are shown schematically in Fig. 2.

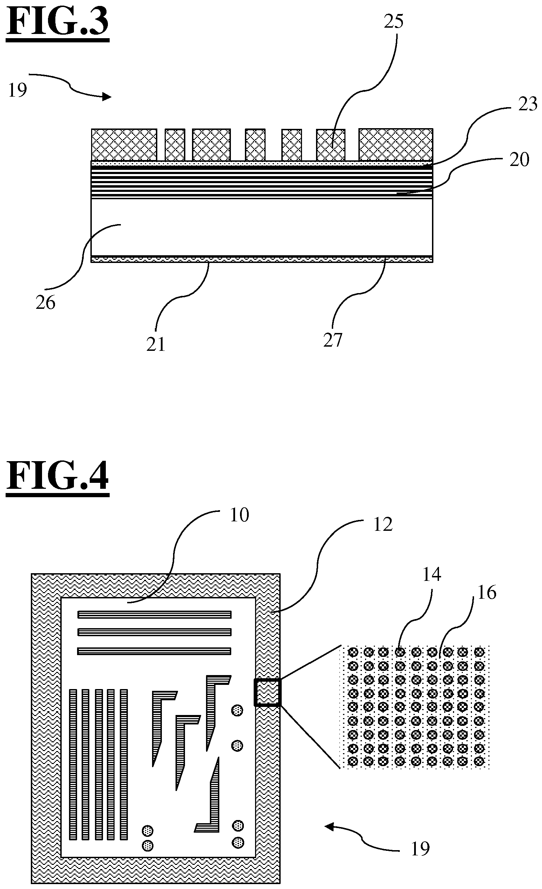

Fig. 3 shows schematically a typical EUV-mask. The substrate 26 may be formed of a material with a low coefficient of thermal expansion (e.g., a material based on fused silica, or another material with a low coefficient of thermal expansion). The low coefficient of thermal expansion may ensure that absorber pattern 22 does not appreciably expand or contract (e.g., the expansion or contraction is too small to effect operation of a component that is produced as a result of the photolithography process) as a result of temperature changes that may be expected during EUV photolithography. A reflective multilayer stack 20 is deposited on one side of the EUV-mask substrate 26. The reflective multilayer coating 20 is very often based on repeated layers of molybdenum and silicon, so called Mo/Si-layers. Several multilayer designs are common in the literature. It is known to use cap-layers 23 or systems of cap-layers on the side of the multilayer 20 that is opposite to the substrate side. These work to protect the multilayer 20 from environmental influences. An example would be the oxidation from traces of oxygen or more commonly water. Current industry standard is a cap-layer 23 of ruthenium. The coating may contain barrier layers (not shown) between the coating materials to prevent interdiffusion of these coating materials. Furthermore not only Mo/Si-layers can be used but they may be designed from different coating materials. Often further multilayers (not shown) are added to provide additional functionality. E.g. anti-stress-layers may be added to reduce the coating stress. The reflective multilayer 20 is added to the mask substrate 26 over the entire area of the EUV-mask 19. This stage with this combination of material and reflective multilayer 20 is sometimes referred to as a mask blank. The mask blank is essentially an EUV-mirror. Finally an absorber material 25 is added on top of the mask blank to provide the pattern structures of the EUV-mask 19. This absorber layer 25 is added within the design region 10 only selectively or added over the whole surface and removed (e.g. by etching) selectively. For example depending on the mask design there may be areas with lines and spaces of absorber material. Typical material that are used as an absorber are Al-Cu, Ti, TiN, Ta, TaN, and Cr. The person skilled in the art knows that several other options exist. In current mask design the height of the absorber is 50-80 nm. The absorber layer 25 has a remaining reflectance of around 1-5% reflectance for EUV light. For example for a 55 nm Absorption layer 25, Ruthenium cap-layer23 , 40 bilayers of Mo/Si as the reflective multilayer 20 on a low thermal expansion substrate 26 the measured EUV reflectivity is 2.7%.

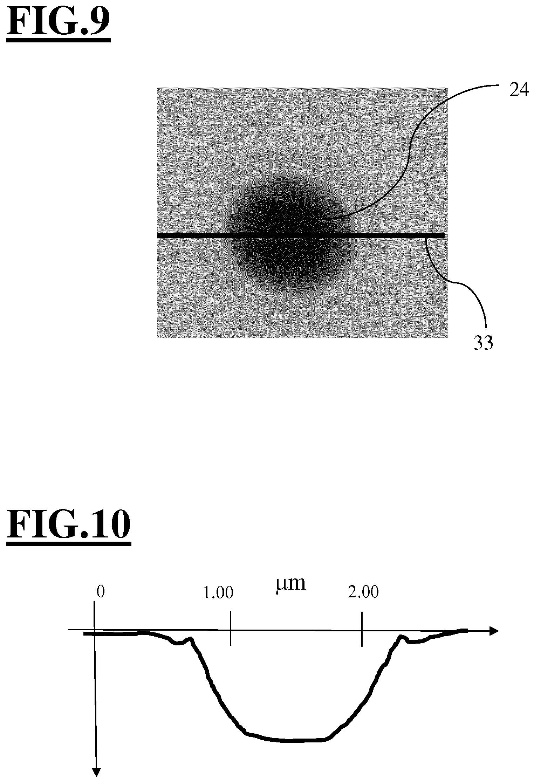

Fig. 4 shows schematically an EUV-mask 19 with a design region 10 and a border region 12 surrounding the design region 10 after being treated by the inventive method. In this case a first set of treatment parameters is determined to produce a reduction in reflectance at a working wavelength of EUV radiation and a first treatment beam with the first set of treatment parameters is directed onto the border region 12. In this case a 200 fs laser is used as the first treatment beam with a 0.4 µm spot size. With this choice of first treatment parameters a first smooth compaction in the border region 12 is introduced. This reduces the reflectance in the border region 12 at a working wavelength of EUV radiation. If the reflectance does not reach the required threshold of 0.05% the reflectance can be enhanced i.e. reduced further with a second treatment. For this a second set of treatment parameters different from the first set of treatment parameters of a second treatment are determined and a second treatment beam with the second set of treatment parameters is directed onto the border region 12. The complete border region 12 or just part may be treated with the first and/or second treatment beam. Fig. 4 also shows an enlarged part of the final treatment of the border region 12. There a smooth in this case constant compaction region 16 is produced by the first treatment beam with the first set of treatment parameters. The second treatment beam with the second treatment parameters produces the distinct compaction areas 14. Their method of production will be further discussed in reference to figs. 9-14. The distinct compaction areas 14 do not only enhance the reduction of reflectance in the border region 12 at the working wavelength of the EUV-radiation but also an wavelength other than the working wavelength of EUV radiation. In this example the reflectance in the DUV region around 100 - 400 nm is reduced below 6%.

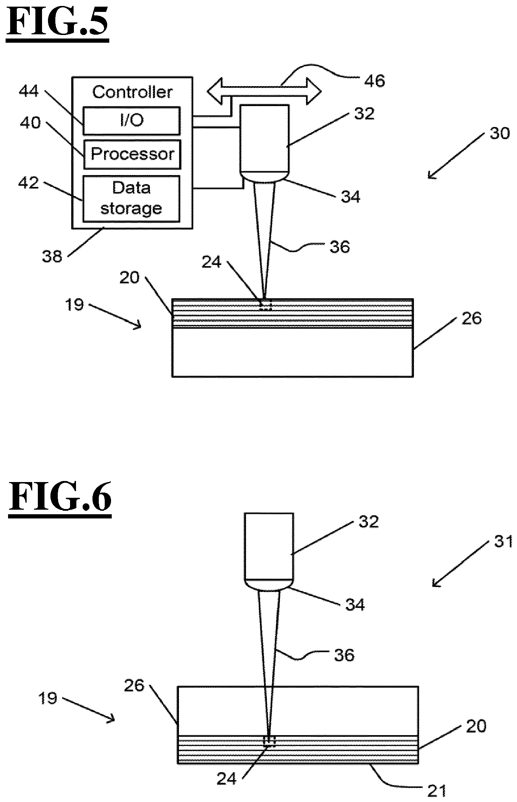

Fig. 5 schematically illustrates a system for treating an reflective EUV-mask for use in photolithography according to an embodiment of the present invention. The photomask treatment system 30 is configured to treat a region of an reflective multilayer 20 of the reflective EUV-mask 19 to form a treated region 24. The photomask treatment system 30 is configured to treat one or more regions of reflective multilayer 20 to form treated multilayer regions 24. A region of the reflective multilayer 20 may be affected by depositing energy within the region. For example, the region may be irradiated by an treatment beam 36, e.g., produced by a laser or otherwise, or otherwise locally heated.

The treatment beam 36 is produced by the treatment radiation source 32. For example, the treatment radiation source 32 may include or represent an ultrashort pulsed laser that produces picosecond pulses or shorter. The ultrashort pulsed laser may be a femtosecond pulsed laser. The treatment beam 36 may be focused, directed, collimated, or otherwise modified by beam optics 34. For example, beam optics 34 may direct treatment beam 36 to scan across a region of reflective multilayer 20 in a predetermined scan pattern, e.g., in a grid pattern. Such a grid pattern may be characterized by such parameters as a pitch (e.g., distance between sequential laser spots) and a scan rate. Such a grid pattern may be configured to deposit a quantity of energy within the region that is sufficient to produce a treated multilayer region 24.

For example, the reflectance of the reflective multilayer 20 prior to treatment may be about 0.7. A treatment to change the reflectance of the reflective multilayer 20 may include irradiation of the reflective multilayer 20 with laser radiation having an energy density in the range of from about 5 mJ/cm² to about 10 J/cm². For example, to change the reflectance from an initial value of about 70% to about 40% (a change of 30%), an energy density of about 2 J/cm2 may be applied. In some cases, an appropriate compensating change in reflectance may be less than 3%. In such a case, the energy density of the irradiation may be about 200 mJ/cm2 or less.

In order to produce a smooth and homogeneous change in the reflectance, a sequence of overlapping laser spots may be scanned over the surface of the reflective multilayer 20 in the form of a grid pattern. The grid pattern may be characterized by a ratio of laser spot diameter to pitch. For example, the ratio of spot diameter to pitch may be in the range of from about 1 to about 100. In some cases, a pattern of non-overlapping laser spots may be applied.

The treatment beam 36 is directed at various regions of the reflective multilayer 20. For example, one or more of the treatment radiation source 32, beam optics 34, or the reflective photomask 19 (or a stage or platform upon which the reflective photomask 19 is mounted) may be configured to move with a one- or two-dimensional translational motion (schematically represented by translation motion 46) relative to one or more other components of photomask treatment system 30.

Operation of one or more components or operations of photomask treatment system 30 may be controlled by controller 38. For example, controller 38 may control operation of one or more of treatment radiation source 32 (e.g., turning on or off, pulse rate or energy, wavelength range, or other parameter of operation of treatment radiation source 32), beam optics 34 (e.g., focus, aperture, scanning rate, grid pattern parameters, or other operation of beam optics 34, translation motion 46 (e.g., of a translation mechanism), or other operation of the photomask treatment system 30.

The controller 38 may include a processor 40. Alternatively or in addition, the controller 38 may include digital or analog circuitry that is configured to control operation of one or more components of the photomask treatment system 30.

For example, the processor 40 may include one or more processing units, e.g. of one or more computers. One or more components of the processor 40 may be incorporated into one or more components of the photomask treatment system 30. The processor 40 may be configured to operate in accordance with programmed instructions.

The processor 40 may communicate with an input/output unit 44. The input/output unit 44 may include a computer monitor or screen. Processor 40 may communicate with the input/output unit 44 to display a status of one or more components of the photomask treatment system 30. In another example, the input/output unit 44 may include a printer, display panel, speaker, or another device capable of producing visible, audible, or tactile output.

The input/output unit 44 may include one or more user-operable controls to enable a user or operator of the photomask treatment system 30 to start, stop, or otherwise control operation of one or more components of the photomask treatment system 30. For example, an input device of the input/output unit 44 may include one or more of a keyboard, keypad, pointing device, touch screen, or control panel for enabling a user to input commands, data, or instructions for operation of processor 40.

The input/output unit 44 may enable communication with, or transfer of data to or from, one or more other devices. For example, input/output unit 44 may enable communication with a system for measuring CD variation during use of the reflective photomask 19 in photolithography. Input/output unit 44 may enable receiving data from inspection unit 29 of an EUV photolithography system.

The processor 40 may communicate with a data storage unit 42. The data storage unit 42 may include one or more fixed or removable, volatile or nonvolatile, memory or data storage devices. The data storage unit 42 may be utilized to store, for example, programmed instructions for operation of processor 40, data or parameters for use by processor 40 during operation, or results of operation of processor 40. For example, the data storage unit 42 may be utilized to store results of inspection of a wafer print that is produced using the reflective EUV-mask 19, and parameters related to treatment of reflective multilayer 20 to produce a treated region 24.

Alternatively or in addition to direct irradiation of reflective multilayer 20 by a treatment beam 36, the reflective multilayer 20 may be treated by a treatment beam that traverses EUV-mask substrate 26. The treatment beam enters the EUV-mask from the side opposite of the multilayer stack and the absorption layer. Fig. 6 schematically illustrates the components of a variation of the system of Fig. 5.

In the alternative photomask treatment system 31, the first or second treatment beam 36 traverses the EUV-mask substrate 26 before impinging on the reflective multilayer 20. In this manner, the first or second treatment beam 36 may avoid irradiating the absorber pattern that is on the exposed side of the reflective multilayer 20. The alternative photomask treatment system 31 may be configured that the treated region 24 is located at a finite depth within the reflective multilayer 20 (e.g., close to the EUV-mask substrate 26). Such irradiation via the EUV-mask substrate 26 may enable finer control of the treatment results than direct irradiation of the multilayer stack through surface 21. For example, a wavelength of treatment radiation source 32 may be selected such that treatment beam 36 may traverse photomask substrate 26 without significant absorption, but is strongly absorbed by the reflective multilayer 20. In some cases, the surface of the EUV-mask substrate 26 opposite the reflective multilayer stack and the absorber layer may include a coating that is transparent to treatment beam 36. It is furthermore advantageous if the transparent coating on the side of the EUV-mask substrate that is opposite the reflective multilayer stack and the absorption layer is electrically conductive.

Heating or other treatment of a region of reflective multilayer 20 to form treated multilayer region 24 may affect the reflectance of treated multilayer region 24.

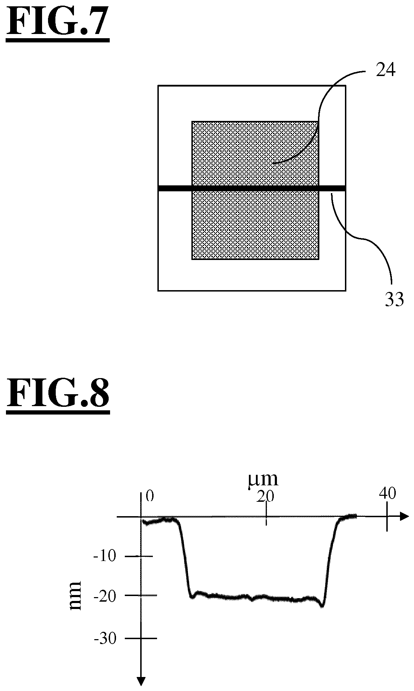

Fig. 7 shows schematically the experimental results of a part of an EUV-mask being treated with a smooth compaction region. In this experiment only a part of an EUV-mask was treated in a treatment region 24 with a first treatment beam. A 200 fs Laser with a spot size of 0.1 µm was used. The superimposed line 33 indicates where a one-dimensional cut was measured. The results of this measurement are shown in Fig.8. A smooth compaction area was produced with a nearly constant cross section in the compaction area. A compaction of around 20 nm was reached. The compaction of the multilayer in turn leads to a reduction in reflectance at a working wavelength of EUV-radiation.

Fig. 9 shows schematically the experimental results of a part of an EUV-mask being treated with a treatment beam to produce a distinct compaction area. In this experiment only a part of an EUV-mask was treated in a treatment region 24 with a first treatment beam. The superimposed line 33 indicates where a one-dimensional cut was measured. In this case a compaction of a troughlike depression was produced. In other experiments not shown similar depressions produced parabolic or Gaussian shapes. Depressions with a depth of up to 150 nm could be produced. The laser fluence of the treatment beam was 0.016 J/cm². This is significantly below the damage threshold for the reflective multilayer stack. As fig. 10 shows, this single distinct compaction area has a diameter of around 1.5 µm.

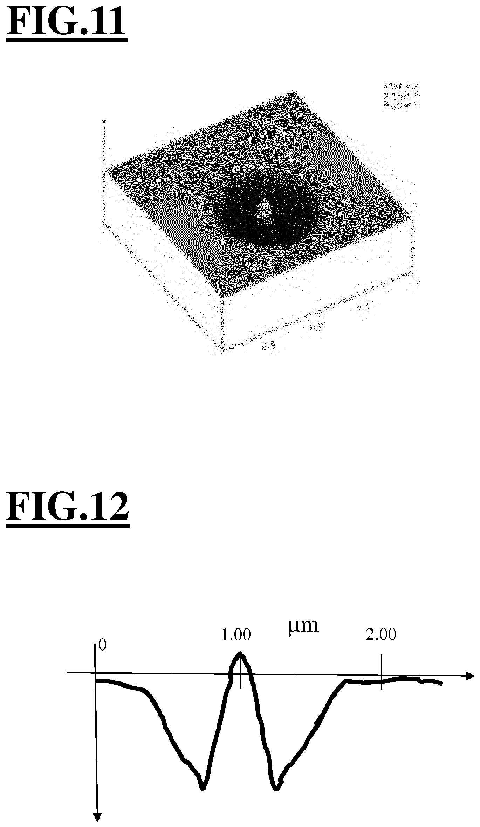

Fig. 11 shows a microscope image of an experiment, where a part of an EUV.mask was treated with a treatment beam with the laser fluence chosen to be 0.032 J/cm². This is double the fluence as in the experiment of fig.9 but it is still below the damage threshold of the reflective multilayer stack. Fig. 12 shows atomic force microscope profile measurements. It is observed that at this fluence a nano-needle in the center of the distinct compaction area can be produced. With this additional structure the reflectance in the border region 12 can be further reduced as well at a working wavelength for EUV radiation as well as at an wavelength other than a working wavelength for EUV-radiation.

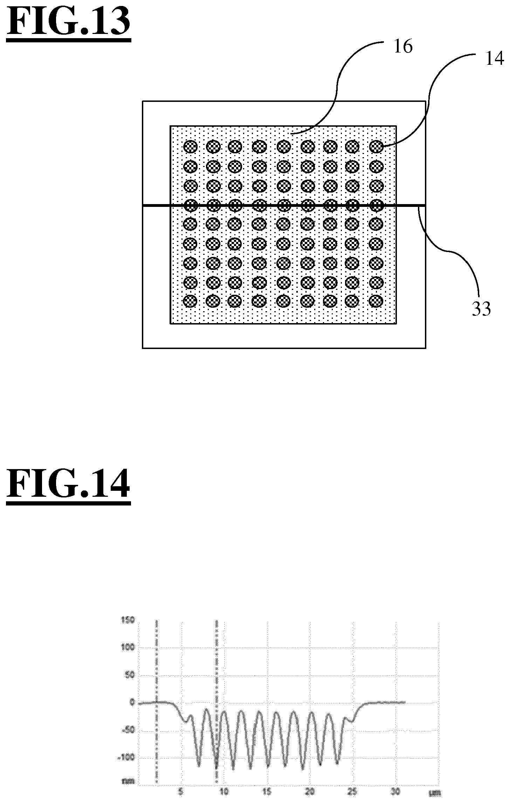

Finally fig. 13 and fig 14 show a combination of a first treatment with a first set of treatment parameters and a second treatment with a second set of treatment parameters. In an area of 20 by 20 µm² a smooth compaction area 16 was produced with a a first femtosecond laser treatment, leading to a reduction in reflectance at a working wavelength of EUV radiation. Subsequently a second treatment with a second set of treatment parameters produced a grid of distinct compaction areas with a pitch of 2 µm in a total area of 18 by 18 µm².

All of the treatments shown in figs. 9-14 can be combined and adjusted. The skilled person can chose from the examples shown a first set of treatment parameters to direct a first treatment beam onto the EUV mask and chose a second set of treatment parameters to direct a second treatment beam onto the EUV mask. Furthermore the order in which the treatments can be applied can be chosen.

## Claims

1. A method of treating a mask for use in extreme ultraviolet (EUV) photolithography, the method comprising:
a. Defining a design region on the mask to be imaged onto a wafer and a border region surrounding the design region,
b. Determining a first set of treatment parameters of a first treatment to produce a reduction in reflectance at a working wavelength of EUV radiation,
c. Directing a first treatment beam with the first set of treatment parameters onto the border region,
d. Determining a second set of treatment parameters different from the first set of treatment parameters of a second treatment to enhance a reduction in reflectance,
e. Directing a second treatment beam with the second set of treatment parameters onto the border region.

2. The method of claim 1, where the border region comprises a substrate, a reflective multilayer structure and an absorber layer.

3. The method of claim 1 or 2 where, the enhancement of step d) occurs at a working wavelength of EUV radiation and/or at an wavelength other than the working wavelength of EUV radiation

4. The method of any of the preceding claims, where the first and/or the second treatment beam is a pulsed laser.

5. The method of any of the preceding claims, where the first set of parameters and/or the second set of parameters comprises a laser spot size on the border region and multiple laser spot positions.

6. The method of any of the preceding claims, where the first treatment introduces a smooth compaction of the border region.

7. The method of claim 6, where the smooth compaction has a constant or a linear or a quadratic cross section.

8. The method of claim 6 or 7, where two or more laser spots impinge on significantly overlapping areas in the border region.

9. The method of any of the preceding claims, where the second treatment introduces a plurality of distinct compaction areas within the border region.

10. The method of any of the preceding claims, where each of the plurality of distinct compaction areas within the border region is shaped as a depression with a central nano-needle.

11. The method of claim 9 or 10, where the distinct compaction areas are arranged in a regular grid.

12. The method of claim 9 or 10, where the distinct compaction areas are arranged in an irregular pattern.

13. The method of claims 9 to 12, where two or more laser spots impinge without overlap in the border region.

14. The method of any of the preceding claims, where the first treatment is applied before the second treatment.

15. The method of any of the preceding claims, the first set of parameters and the second set of parameters comprise a laser fluence on the border region.

16. The method of claim 15, where the peak laser fluence on the border region in the first treatment is lower than the peak laser fluence on the border region in the second treatment.

17. The method of any of the preceding claims, where the first treatment and the second treatment are applied from the surface of the substrate opposite to the multilayer stack and the absorber pattern.

18. A mask for use in extreme ultraviolet (EUV) photolithography treated with a method according to one of the preceding claims.
